# FASCICULE DE BREVET EUROPEEN

(11) **EP 3 807 940 B1**
(45) Date de publication et mention de la délivrance du brevet: **03.08.2022**
(21) Numéro de dépôt: 19746116.3
(22) Date de dépôt: 11.06.2019
(51) Int. Cl.: H01L 33/08, H01L 33/18, H01L 25/16, H01L 33/62, H01L 33/32

(54) **DISPOSITIF OPTOÉLECTRONIQUE**
OPTOELEKTRONISCHE VORRICHTUNG
OPTOELECTRONIC DEVICE

(30) Priorité: 14.06.2018 FR 1870698
(43) Date de publication de la demande: 21.04.2021
(73) Titulaire: Aledia, 38130 Echirolles (FR)
(72) Inventeur: ROBIN, Ivan-Christophe, 38000 GRENOBLE (FR)
(74) Mandataire: Cabinet Beaumont
(86) Numéro de dépôt international: PCT/FR2019/051410
(87) Numéro de publication internationale: WO 2019/239059

(56) Documents cités:
- EP-A1- 3 070 752
- EP-A1- 3 401 958
- WO-A1-2011/048318
- WO-A1-2018/002485
- FR-A1- 3 023 066
- US-A1- 2017 358 562

## Description

La présente demande de brevet revendique la priorité de la demande de brevet français FR18/70698.

### Domaine technique

La présente demande concerne un dispositif optoélectronique, notamment un écran d'affichage ou un dispositif de projection d'images, comprenant des diodes électroluminescentes, à base de matériaux semiconducteurs, et leurs procédés de fabrication.

### Technique antérieure

Un pixel d'affichage d'une image correspond à l'élément unitaire de l'image affichée par le dispositif optoélectronique. Lorsque le dispositif optoélectronique est un écran d'affichage d'images couleur, il comprend, en général, pour l'affichage de chaque pixel d'affichage de l'image, au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel d'affichage de l'image affichée. Dans ce cas, on appelle pixel d'affichage du dispositif optoélectronique l'ensemble formé par les trois sous-pixels d'affichage utilisés pour l'affichage d'un pixel d'affichage d'une image.

Chaque sous-pixel d'affichage peut comprendre une source lumineuse, notamment une ou plusieurs diodes électroluminescentes par exemple à base de matériaux semiconducteurs. Un procédé connu de fabrication d'un dispositif optoélectronique, notamment un écran d'affichage ou un dispositif de projection d'images, comprenant des diodes électroluminescentes, appelé procédé "pick and place", consiste à fabriquer les diodes électroluminescentes sous la forme de composants distincts, et à placer chaque diode électroluminescente à une position souhaitée sur un support qui peut comprendre des pistes conductrices pour la connexion électrique des diodes électroluminescentes.

Un inconvénient d'un tel procédé est qu'il nécessite généralement de placer avec précision les diodes électroluminescentes sur le support. Ceci nécessite la mise en oeuvre de procédés d'alignement d'autant plus complexes que les dimensions des diodes électroluminescentes sont réduites.

Un autre inconvénient d'un tel procédé est qu'une augmentation de la résolution du dispositif optoélectronique se traduit par une augmentation du nombre de transferts de diodes électroluminescentes sur le support et donc une augmentation de la durée de la fabrication du dispositif optoélectronique qui peut ne pas être compatible avec une fabrication à une échelle industrielle.

Pour la réalisation d'un grand écran d'affichage à diodes électroluminescentes composé de diodes électroluminescentes unitaires assemblées, les diodes électroluminescentes doivent être assemblées avec des circuits de commande qui contrôlent un certain nombre de diodes électroluminescentes. Les ensembles comprenant les circuits de commande et les diodes électroluminescentes sont alors reliés entre eux par des fils. Cet assemblage réduit la quantité de données pouvant être transmises et il peut être difficile d'afficher un flux vidéo.

Pour les écran d'affichage comprenant des diodes électroluminescentes de taille micrométriques, par exemple pour les formats type TV, tablette, téléphone intelligent (en anglais smart phone) qui sont en cours de développement par plusieurs industriels, une matrice active est nécessaire pour afficher un flux vidéo avec une haute résolution. Actuellement, les matrices actives pour les écrans d'affichage sont réalisées avec des transistors en couches minces, ou TFT (sigle anglais pour Thin Film Transistor). Les TFT utilisent généralement des dépôts de silicium amorphe ou polycristallin sur de grandes surfaces de verre et nécessitent l'utilisation de procédés de microélectronique complexes sur de grandes surfaces.

Il serait souhaitable de pouvoir réaliser des pixels d'affichage dits intelligents intégrant avec les diodes électroluminescentes, notamment de taille micrométrique, de l'électronique de commande de façon à réaliser des matrices actives sans TFT. Ces matrices actives pourraient être réalisées sur de très grandes surfaces car elles s'appuient sur des circuits électroniques embarqués sous le pixel d'affichage. D'autre part ces circuits électroniques pourraient profiter des performances des technologies à base de silicium.

WO 2011/048318 A1, FR 3 023 066 A1 et US 2017/358562 A1 divulguent des écrans d'affichage haute résolution de l'art antérieur, intégrant avec une haute densité des diodes électroluminescentes filaires sur une matrice active.

### Résumé de l'invention

Un mode de réalisation prévoit un procédé de fabrication d'un dispositif optoélectronique comprenant les étapes suivantes :
former, sur une première face d'une première plaque comprenant des ensembles de composants électroniques, un empilement de premières couches isolantes et de pistes conductrices ;
former, sur une deuxième plaque, des ensembles de diodes électroluminescentes tridimensionnelles comprenant chacune des première et deuxième extrémités ;
former une première couche métallique sur au moins une partie de la première face de la première plaque et une deuxième couche métallique sur au moins une partie d'une première face de la deuxième plaque, la deuxième couche métallique étant couplée électriquement à la première extrémité de chaque diode électroluminescente ;
mettre en contact les première et deuxième couches métalliques pour les fixer par collage moléculaire ;
former au moins un via conducteur isolé connectant une seconde face de la première plaque à l'une des pistes conductrices ; et
former, après la mise en contact des premières et deuxième couches métalliques, des tranchées conductrices isolées entourant chaque ensemble de diodes électroluminescentes et isolant latéralement les unes des autres des parties des première et deuxième couches métalliques, chaque partie étant connectée à l'un des ensembles de diodes électroluminescentes.

Selon un mode de réalisation, certaines des pistes conductrices connectent entre eux des composants électroniques de la première plaque et des éléments conducteurs s'étendent dans les premières couches isolantes de l'empilement et sont en contact avec la première couche métallique.

Selon un mode de réalisation, chaque partie des première et deuxième couches métalliques entourée par une tranchée est connectée à la première plaque par l'un des éléments conducteurs.

Selon un mode de réalisation, les première et deuxième couches métalliques recouvrent entièrement les premières faces des première et deuxième plaques.

Selon un mode de réalisation, le procédé comprend une étape de formation d'une électrode connectant électriquement les deuxièmes extrémités de toutes les diodes électroluminescentes.

Selon un mode de réalisation, les tranchées conductrices isolées s'étendent de l'électrode à certaines des pistes conductrices.

Selon un mode de réalisation, les tranchées conductrices isolées s'étendent de la seconde face de la première plaque jusqu'à l'électrode.

Selon un mode de réalisation, les première et deuxième couches métalliques sont mises en contact avant la formation d'une couche photoluminescente recouvrant l'électrode.

Selon un mode de réalisation, chaque tranchée est connectée à l'un des vias conducteurs isolés.

Selon un mode de réalisation, le procédé comprend la formation d'une deuxième couche isolante électriquement recouvrant les diodes électroluminescentes, la deuxième couche isolante étant traversée par des murs conducteurs électriquement.

Selon un mode de réalisation, chaque ensemble de composants électroniques comprend un circuit de commande des diodes électroluminescentes de l'ensemble de diodes électroluminescentes correspondant.

Selon un mode de réalisation, le procédé comprend une étape d'amincissement de la deuxième plaque avant la formation de la deuxième couche métallique.

Selon un mode de réalisation, les diodes électroluminescentes 3D sont des diodes filaires, coniques ou tronconiques.

Selon un mode de réalisation, le procédé comprend une étape au cours de laquelle les première et deuxième plaques sont gravées de manière à former des puces.

Un autre mode de réalisation prévoit un dispositif optoélectronique comprenant :
une première plaque comprenant des ensembles de composants électroniques et un empilement de premières couches isolantes et des pistes conductrices, une première face de la première plaque étant au moins partiellement recouverte d'une première couche métallique, au moins un via conducteur isolé connectant une seconde face de la première plaque à l'une des pistes conductrices ;
une deuxième plaque comprenant des ensembles de diodes électroluminescentes tridimensionnelles, chaque diode électroluminescente ayant une première et une deuxième extrémité, une première face de la deuxième plaque étant au moins partiellement recouverte d'une deuxième couche métallique, la deuxième couche métallique étant couplée électriquement aux premières extrémités de toutes les diodes électroluminescentes, les première et deuxième couches métalliques étant fixées l'une à l'autre par collage moléculaire ; et
des tranchées conductrices isolées entourant chaque ensemble de diodes électroluminescentes et isolant latéralement des parties des première et deuxième couches métalliques connectées à chaque ensemble de diodes électroluminescentes.

Selon un mode de réalisation, certaines des pistes conductrices connectent entre eux des composants électroniques de la première plaque et des éléments conducteurs compris dans les premières couches isolantes de l'empilement sont en contact avec la première couche métallique.

Selon un mode de réalisation, chaque partie des première et deuxième couches métalliques entourée par une tranchée est connectée à la première plaque par l'un des éléments conducteurs.

Selon un mode de réalisation, les première et deuxième couches métalliques recouvrent entièrement les premières faces des première et deuxième plaques.

Selon un mode de réalisation, une électrode connecte électriquement les deuxièmes extrémités toutes les diodes électroluminescentes.

Selon un mode de réalisation, les tranchées conductrices isolées s'étendent de l'électrode à une piste conductrice de l'empilement.

Selon un mode de réalisation, les tranchées conductrices isolées s'étendent de la seconde face de la première plaque à l'électrode.

Selon un mode de réalisation, chaque tranchée est connectée à un des vias conducteurs isolés.

Selon un mode de réalisation, une deuxième couche isolante électriquement recouvre les diodes électroluminescentes, la couche isolante étant traversée par des murs conducteurs électriquement.

Selon un mode de réalisation, la deuxième couche métallique est en contact avec les premières extrémités des diodes électroluminescentes.

Selon un mode de réalisation, chaque ensemble de composants électroniques comprend un circuit de commande des diodes électroluminescentes d'un ensemble de diodes électroluminescentes correspondant.

Selon un mode de réalisation, les diodes électroluminescentes 3D sont des diodes filaires, coniques ou tronconiques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une partie d'un mode de réalisation d'un dispositif optoélectronique ;
la figure 2 illustre le résultat d'étapes d'un mode de réalisation d'un procédé de fabrication du dispositif de la figure 1 ;
la figure 3 illustre le résultat d'étapes d'un mode de réalisation d'un procédé de fabrication du dispositif de la figure 1 ;
la figure 4 illustre le résultat d'étapes d'un mode de réalisation d'un procédé de fabrication du dispositif de la figure 1 ;
la figure 5 illustre le résultat d'étapes d'un mode de réalisation d'un procédé de fabrication du dispositif de la figure 1 ;
la figure 6 illustre le résultat d'étapes d'un mode de réalisation d'un procédé de fabrication du dispositif de la figure 1 ;
la figure 7 illustre le résultat d'étapes d'un mode de réalisation d'un procédé de fabrication du dispositif de la figure 1 ;
la figure 8 illustre le résultat d'étapes d'un mode de réalisation d'un procédé de fabrication du dispositif de la figure 1 ;
la figure 9 illustre une partie d'un autre mode de réalisation d'un dispositif optoélectronique ;
la figure 10 illustre le résultat d'étapes du mode de réalisation d'un procédé de fabrication du dispositif de la figure 9 ;
la figure 11 illustre le résultat d'étapes du mode de réalisation d'un procédé de fabrication du dispositif de la figure 9 ;
la figure 12 illustre une partie d'un autre mode de réalisation d'un dispositif optoélectronique ;
la figure 13 illustre le résultat d'étapes du mode de réalisation d'un procédé de fabrication du dispositif de la figure 12 ; et
la figure 14 illustre le résultat d'étapes du mode de réalisation d'un procédé de fabrication du dispositif de la figure 12.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des dispositifs décrits ne seront pas détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un ... dans une position normale d'utilisation.

On considère ici que les termes "isolant" et "conducteur" signifient "isolant électriquement" et "conducteur électriquement".

Sauf précision contraire, les expressions "environ", "approximativement", "sensiblement", et "de l'ordre de" signifient à 10 % près, de préférence à 5 % près.

La présente description concerne des dispositifs optoélectroniques à éléments tridimensionnels ou 3D, par exemple des éléments filaires (microfils ou nanofils), des éléments coniques ou des éléments tronconiques. Plus précisément, les dispositifs décrits comprennent des diodes électroluminescentes filaires. Toutefois, ces modes de réalisation peuvent être mis en oeuvre pour des éléments tridimensionnels autres que des diodes filaires, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

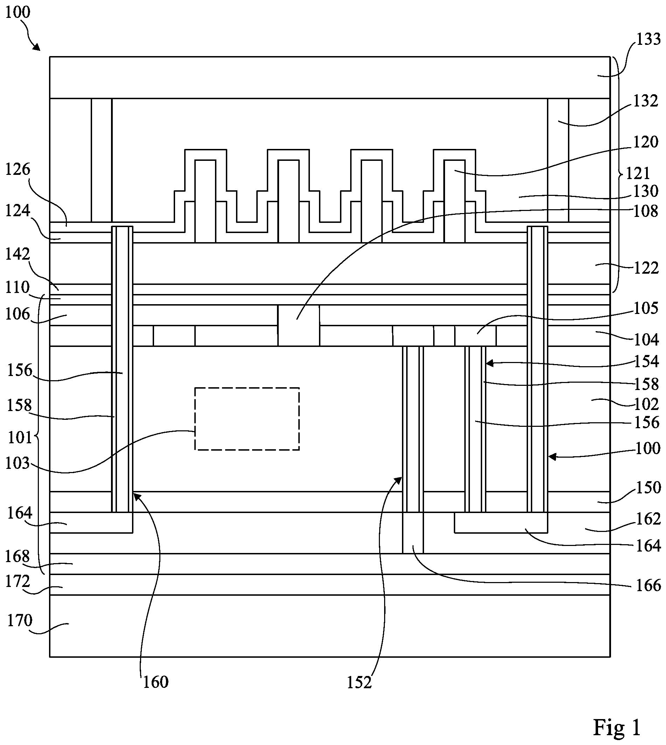

La figure 1 représente une partie d'un mode de réalisation d'un dispositif optoélectronique 100, par exemple un écran d'affichage. Plus précisément, la figure 1 représente un sous-pixel d'affichage d'un pixel d'affichage du dispositif optoélectronique 100. Le pixel d'affichage comprend par exemple plusieurs sous-pixels d'affichage, par exemple au moins trois sous-pixels d'affichage. Un tel pixel d'affichage comprend par exemple au moins un sous-pixel d'affichage adapté à fournir un rayonnement bleu, un sous-pixel d'affichage adapté à fournir un rayonnement rouge et un sous-pixel d'affichage adapté à fournir un rayonnement vert.

Le pixel d'affichage comprend un circuit électronique 101. Le circuit 101 comprend un substrat semiconducteur 102 dans et sur lequel des ensembles de composants électroniques 103, représentés de manière très schématique en figure 1, sont formés. Plus précisément, chaque sous-pixel d'affichage comprend un ensemble de composants électroniques 103.

Le substrat 102 est recouvert d'un empilement d'au moins une couche isolante, l'empilement comprenant en outre des pistes conductrices 105 d'un premier niveau de métallisation. En figure 1, l'empilement comprend deux couches isolantes 104 et 106. Les pistes conductrices 105 de la couche 104 servent par exemple à interconnecter des composants électroniques 103 d'un même ensemble.

Le pixel d'affichage comprend, de plus, un circuit optoélectronique 121. Le circuit 121 comprend un substrat semiconducteur 122 sur lequel sont formés des ensembles de diodes électroluminescentes 120. Plus précisément, le pixel d'affichage comprend autant d'ensembles de diodes électroluminescentes que de sous-pixels d'affichage, chaque sous-pixel d'affichage comprenant un ensemble de diodes électroluminescentes.

Les diodes électroluminescentes 120 sont des diodes tridimensionnelles telles que cela a été écrit précédemment. Un exemple de diodes électroluminescentes 120 est décrit dans la demande de brevet US 2015/0255677. Un unique ensemble de diodes électroluminescentes 120 est représenté en figure 1, cet ensemble comprenant quatre diodes électroluminescentes. En pratique, un ensemble de diodes électroluminescentes peut comprendre entre une et plusieurs dizaines de diodes électroluminescentes.

Chaque ensemble de composants électroniques 103 comprend par exemple un circuit de commande de diodes électroluminescentes. Ces ensembles de composants électroniques 103 sont par exemple adaptés à commander un ensemble de diodes électroluminescentes à partir de la modulation de la tension aux bornes des ensembles de diodes électroluminescentes. De tels circuits sont décrits dans la demande de brevet française FR1756984 de la demanderesse.

Le circuit électronique 101 comprend une couche métallique 110, recouvrant la couche isolante 106, et le circuit optoélectronique 121 comprend une couche métallique 142, recouvrant la face du substrat 122 opposée aux diodes électroluminescentes 120. Les couches métalliques 110 et 142 sont en contact l'une avec l'autre. Les couches métalliques 110 et 142 sont collées par collage moléculaire métal/métal et permettent de fixer le circuit électronique 101 au circuit optoélectronique 121.

Le circuit électronique 101 comprend un élément conducteur 108, comprenant par exemple des pistes conductrices situées dans les couches 104 et 106. L'élément conducteur 108 permet de former une connexion électrique entre chaque ensemble de composants électroniques 103 et la couche métallique 110. L'élément conducteur 108 permet donc, pour chaque ensemble de composants électroniques 103, de former une connexion électrique entre l'ensemble de composants électroniques 103 d'un sous-pixel d'affichage et le substrat 122 du même sous-pixel d'affichage par l'intermédiaire des couches métalliques 110 et 142.

Le circuit optoélectronique 121 comprend une couche isolante 124 qui recouvre le substrat 122 autour des diodes électroluminescentes 120 et qui recouvre une partie inférieure de chaque diode électroluminescente. Le circuit optoélectronique 121 comprend, en outre, une couche conductrice 126 qui recouvre entièrement le substrat 122, c'est-à-dire qu'elle recouvre la couche isolante 124 et les parties des diodes électroluminescentes 120 non recouvertes par la couche isolante 124. La couche conductrice 126 est au moins partiellement transparente au rayonnement émis par les diodes électroluminescentes. La couche conductrice 126 correspond à une électrode des diodes électroluminescentes 120. Cette électrode est, de préférence, une électrode commune à toutes les diodes électroluminescentes 120 du sous-pixel d'affichage.

Le circuit optoélectronique 121 comprend, pour chaque sous-pixel d'affichage, une couche photoluminescente et isolante 130 recouvrant la partie de la couche conductrice 126 associée au sous pixel d'affichage. La couche photoluminescente 130 est par exemple adaptée à absorber au moins une partie du rayonnement émis par les diodes électroluminescentes et à émettre un rayonnement à une autre longueur d'onde. La couche photoluminescente 130 comprend par exemple des boites quantiques ou des luminophores. La composition de la couche photoluminescente 130 diffère selon le sous-pixel d'affichage considéré. Ainsi, certaines couches photoluminescentes 130 peuvent être adaptées à transformer le rayonnement émis par les diodes électroluminescentes du sous-pixel d'affichage en un rayonnement bleu, vert ou rouge.

À titre de variante, le substrat 122 peut être absent. La couche métallique 142 est alors directement en contact avec les diodes électroluminescentes 120 et la couche isolante 124 ou avec une couche de nucléation conductrice permettant la croissance de celle-ci.

Le circuit optoélectronique 121 comprend des murs conducteurs 132 qui s'étendent de la couche 126 à la face des couches photoluminescentes 130 opposée au substrat 122. Par exemple, les murs 132 entourent chaque ensemble de diodes électroluminescentes 120.

Le circuit optoélectronique 121 comprend une couche conductrice 133 au moins partiellement transparente au rayonnement émis par le pixel d'affichage, et recouvrant les couches photoluminescentes 130. La couche conductrice 133 est par exemple en contact, et est par exemple connectée électriquement avec les extrémités des murs 132.

A titre de variante, la couche photoluminescente 130 peut recouvrir de manière conforme les diodes électroluminescentes 120 et être recouverte d'une couche isolante et transparente, par exemple en silicium.

Le circuit électronique 101 comprend de plus une couche isolante 150 située sur la face du substrat 102 opposée aux couches isolantes 104 et 106. Des vias conducteurs isolés 152 et 154 traversent la couche isolante 150 et le substrat 102 de manière à atteindre certaines des pistes conductrices 105. Les vias conducteurs isolés 152 et 154 comprennent chacun un coeur 156 conducteur entouré d'une gaine 158 isolante ouverte aux extrémités des vias de manière à permettre une connexion électrique.

Le pixel d'affichage comprend, de plus, des tranchées conductrices isolées 160 situées de manière à entourer chaque sous-pixel d'affichage. Chaque tranchée 160 comprend, comme les vias 152 et 154, une gaine isolante 158 et un coeur conducteur 156. Les tranchées 160 traversent la couche isolante 150, le substrat 102, les couches isolantes 104 et 106, les couches métalliques 110 et 142, le substrat 122 (s'il est présent), et la couche isolante 124. Les tranchées 160 délimitent des portions du substrat 122 sous chaque ensemble de diodes électroluminescentes 120. Les portions délimitées sont isolées électriquement du reste du substrat 122. De préférence, les couches 110 et 142 recouvrent entièrement, respectivement, les faces du circuit électronique 101 et du circuit optoélectronique 121 sur lesquelles elles sont formées, à l'exception des tranchées 160.

Le circuit électronique 101 comprend un empilement de couches isolantes 162, comprenant, en outre, des pistes conductrices, formé sur la face de la couche isolante 150 opposée au substrat 102. En particulier, des pistes conductrices 164 sont formées de manière à connecter une extrémité d'une des tranchées 160 à une extrémité d'un via 154 de chaque sous-pixel d'affichage. De plus, le circuit électronique 101 comprend une couche métallique 168 recouvrant la face de l'empilement de couches 162 opposée à la couche isolante 150. L'empilement de couches 162 comprend des éléments conducteurs 166, comprenant par exemple des pistes conductrices situées dans les couches 162. Les éléments conducteurs 166 permettent de connecter une extrémité d'au moins un via 152 de chaque sous-pixel d'affichage à la couche métallique 168.

Le pixel d'affichage est fixé à un support 170 par collage moléculaire métal/métal entre la couche métallique 168 et une couche métallique formant un plot 172 situé sur le support 170.

À titre de variante, le support 170 peut ne pas être recouvert de la couche métallique 172 mais d'un empilement d'au moins une couche isolante et de premières pistes conductrices. De plus, l'empilement de couches 162 peut comprendre des secondes pistes conductrices en regard des premières pistes conductrices. Les premières pistes conductrices sont situées de telle manière que chaque première piste soit en contact avec une seconde piste. Les couches isolantes comprenant les premières et secondes pistes sont ainsi collées par collage moléculaire hybride. Les circuits électroniques 101 et optoélectroniques 121 peuvent être fixés les uns aux autres similairement.

En fonctionnement, un premier potentiel d'alimentation, par exemple un potentiel haut, est appliqué à la couche conductrice 133. Ce potentiel d'alimentation est donc appliqué à une première extrémité des diodes électroluminescentes 120 par l'intermédiaire des murs 132 et de la couche conductrice 126. Ce potentiel d'alimentation est de plus fourni à l'ensemble de composants électroniques 103 de chaque sous-pixel d'affichage par l'intermédiaire des tranchées 160, des pistes conductrices 164, des vias 154 et des pistes conductrices 105. Les ensembles de composants électroniques 103 sont aussi connectés à un deuxième potentiel d'alimentation, par exemple un potentiel bas, par exemple la masse, par l'intermédiaire de pistes conductrices 105, des vias 152, des éléments conducteurs 166, de la couche conductrice 168, des plots 172 et du support 170.

L'ensemble de composants électroniques 103 de chaque sous-pixel d'affichage fournit, à partir de ces potentiels, un signal de commande fourni aux deuxièmes extrémités des diodes électroluminescentes 120 par l'intermédiaire de l'élément conducteur 108, des parties des couches métalliques 110 et 142 entourées par les tranchées 160 et du substrat 122.

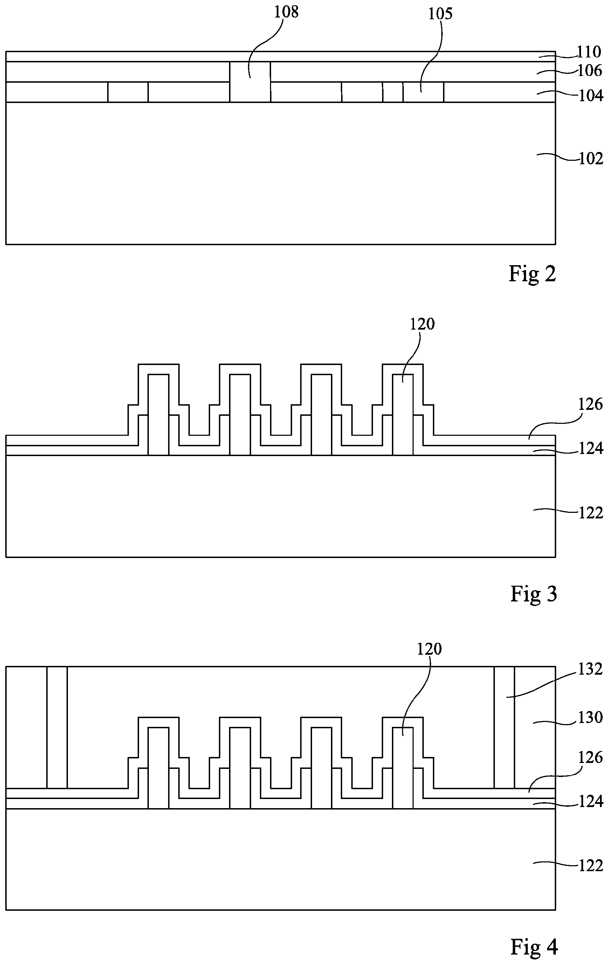

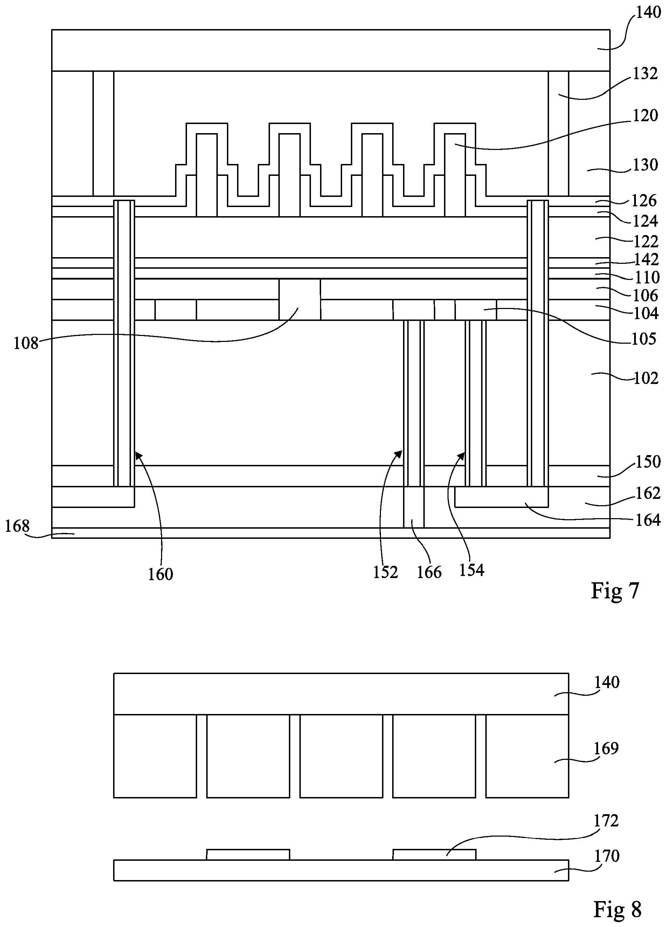

Les figures 2 à 8 illustrent les résultats d'étapes, de préférence successives, d'un mode de réalisation d'un procédé de fabrication du dispositif optoélectronique 100 de la figure 1. Plus précisément, les figures 2 à 7 illustrent la fabrication d'un sous-pixel d'affichage comprenant un ensemble de diodes électroluminescentes et un ensemble de composants électroniques. La figure 8 illustre la mise en place des pixels d'affichage.

Les substrats 102 et 122 peuvent chacun correspondre à une structure monobloc ou correspondre à une couche recouvrant un support constitué d'un autre matériau. Les substrats 102 et 122 sont de préférence chacun un substrat semiconducteur, par exemple un substrat en silicium, en germanium, en carbure de silicium, en un composé III-V, ou en un composé II-VI, par exemple en ZnO. Les substrats 102 et 122 peuvent aussi être en saphir ou en graphène. De préférence, les substrats 102 et 122 sont des substrats de silicium monocristallin. De préférence, il s'agit de substrats semiconducteurs compatibles avec les procédés de fabrication mis en oeuvre en microélectronique. Les substrats 102 et 122 peuvent correspondre à une structure multicouches de type silicium sur isolant, également appelée SOI (acronyme anglais pour Silicon On Insulator). Les substrats 102 et 122 peuvent être fortement dopés, faiblement dopés ou non dopés.

Des exemples d'éléments chimiques du groupe II comprennent des éléments chimiques du groupe IIA, notamment le béryllium (Be) et le magnésium (Mg), et des éléments chimiques du groupe IIB, notamment le zinc (Zn), le cadmium (Cd) et le mercure (Hg). Des exemples d'éléments chimiques du groupe VI comprennent des éléments chimiques du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments chimiques dans le composé II-VI peuvent être combinés avec différentes fractions molaires.

Des exemples d'éléments chimiques du groupe III comprennent le gallium (Ga), l'indium (In) ou l'aluminium (Al). Des exemples d'éléments chimiques du groupe V comprennent l'azote, le phosphore ou l'arsenic. Des exemples de composés III-N sont GaN, AlN, InN, InGaN, AlGaN ou AlInGaN. De façon générale, les éléments chimiques dans le composé III-V peuvent être combinés avec différentes fractions molaires.

Les différents éléments isolants (couches, gaines) peuvent être en un matériau diélectrique ou comprendre un empilement de couches diélectriques, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant.

Les coeurs conducteurs 156 sont en un matériau de remplissage. Le matériau de remplissage peut correspondre à un matériau semiconducteur ou conducteur électriquement. Les coeurs conducteurs sont, par exemple, en silicium, en germanium, en carbure de silicium, en un composé III-V, tel que du GaN, du InP ou du GaAs, en un composé II-VI, par exemple du ZnO, en tungstène (W) ou en cuivre (Cu). De préférence, chaque coeur conducteur est en silicium polycristallin. De préférence, chaque coeur conducteur est en un matériau compatible avec les procédés de fabrication mis en oeuvre en microélectronique. Chaque coeur conducteur peut être fortement dopé, faiblement dopé ou non dopé.

La figure 2 illustre partiellement la formation du circuit électronique 101 et plus particulièrement le résultat d'une étape au cours de laquelle les ensembles de composants électroniques (non représentés) sont formés dans et sur le substrat 102. A ce stade du procédé de fabrication, le substrat 102 correspond à une plaque (wafer) et sert à la formation simultanée de circuits électroniques 101.

En particulier, l'empilement de couches isolantes 104 et 106 et les pistes conductrices 105 sont formés. Les éléments conducteurs 108 sont aussi formés. La couche 106 est recouverte, sur l'ensemble de la plaque 102, par la couche métallique 110.

La figure 3 illustre partiellement la formation du circuit optoélectronique 121 et plus précisément le résultat d'une étape au cours de laquelle les ensembles de diodes électroluminescentes 120 sont formés sur le substrat 122. Un unique ensemble de diodes électroluminescentes 120 est représenté en figure 3, cet ensemble comprenant quatre diodes électroluminescentes élémentaires. En pratique, un ensemble de diodes électroluminescentes peut comprendre entre une et plusieurs centaines de diodes électroluminescentes.

A ce stade du procédé de fabrication, le substrat 122 correspond à une plaque (wafer) et comprend un grand nombre d'ensembles de diodes électroluminescentes. De préférence, la plaque correspondant au substrat 122 a sensiblement les mêmes dimensions que la plaque correspondant au substrat 102 et le nombre d'ensembles de diodes électroluminescentes 120 correspond au nombre d'ensembles de composants électroniques 103.

La couche isolante 124 et la couche conductrice 126, formant l'électrode, sont formées sur l'ensemble de la plaque du substrat 102. L'électrode 126 est, de préférence, commune à toutes les diodes électroluminescentes 120 de la plaque.

La figure 4 illustre le résultat d'une autre étape au cours de laquelle les murs conducteurs 132 sont formés sur la couche conductrice 126. La couche photoluminescente 130 est formée, pour chaque sous-pixel d'affichage, dans l'emplacement délimité par les murs 132.

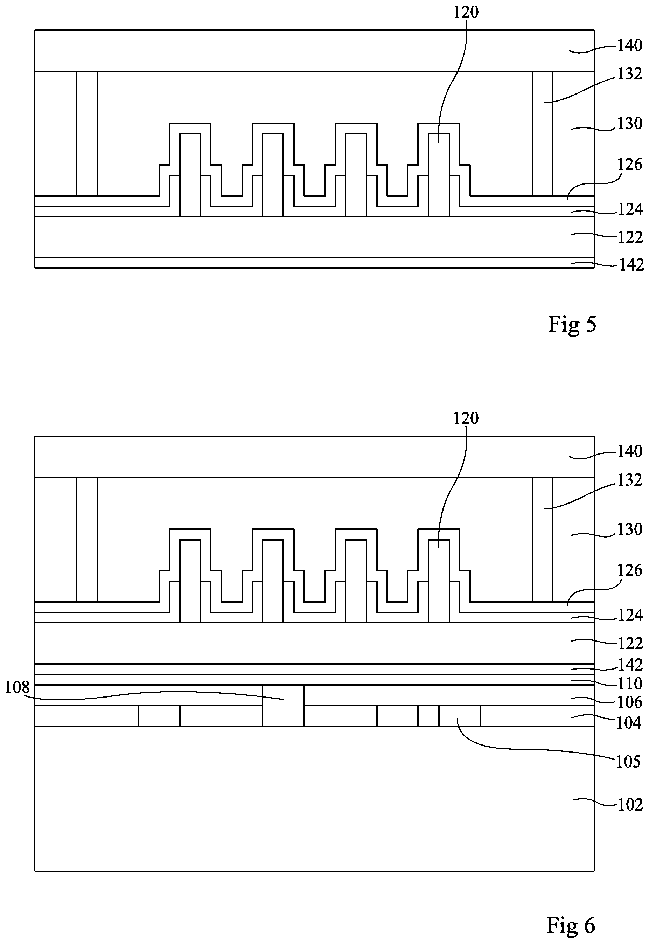

La figure 5 illustre une autre étape au cours de laquelle une poignée 140 est fixée à la face libre des couches photoluminescentes 130.

Le substrat 122 est ensuite aminci. La couche métallique 142 est formée sur la face libre du substrat 122, c'est-à-dire la face opposée à la face sur laquelle sont formées les diodes électroluminescentes 120. La couche métallique 142 est formée sur l'ensemble de la plaque. La poignée 140 permet la manipulation de la plaque 122 sans causer de déformation au niveau de la plaque au cours de l'étape d'amincissement et après cette étape. La couche métallique 142 recouvre, par exemple, entièrement le substrat 122.

À titre de variante, le substrat 122 peut être entièrement retiré. La couche métallique 142 est alors formée directement au contact de la couche isolante 124 et d'une extrémité de chaque diode électroluminescente 120.

La figure 6 illustre une autre étape au cours de laquelle la plaque de circuits optoélectroniques et la plaque de circuits électroniques sont mises en contact l'une avec l'autre. Plus précisément, les couches métalliques 142 et 110 sont mises en contact l'une avec l'autre. Les deux plaques sont donc fixées par collage moléculaire métal/métal. Chaque ensemble de diodes électroluminescentes est situé sensiblement en regard d'un ensemble de composants électroniques 103 adaptés à commander cet ensemble de diodes électroluminescentes. Il y a ainsi une connexion électrique, par l'intermédiaire du substrat 122, des couches 142 et 110 et de l'élément conducteur 108, entre une des extrémités de chaque diode électroluminescente 120 d'un ensemble de diodes photoluminescentes et les composants électroniques de l'ensemble de composants électroniques 103 associé.

La figure 7 illustre le résultat d'une étape au cours de laquelle la couche isolante 150 est déposée sur la face libre du substrat 102. Les vias conducteurs isolés 152 et 154 sont formés à travers la couche isolante 150 et le substrat 102 de manière à atteindre certaines des pistes conductrices.

Les tranchées conductrices isolées 160 sont formées de manière à entourer chaque sous-pixel d'affichage. Les tranchées 160 traversent la couche isolante 150, le substrat 102, les couches 104 et 106, les couches métalliques 110 et 142, le substrat 122 (s'il n'a pas été entièrement retiré), et la couche isolante 124. Les tranchées 160 connectent donc la face libre de la couche isolante 150 à l'électrode 126.

Les couches isolantes 162 et les pistes conductrices 164 et 166 sont formées sur la face libre de la couche isolante 150. En particulier, les pistes conductrices 164 sont formées de manière à connecter une extrémité des tranchées 160 à une extrémité d'un via 154 de chaque sous-pixel d'affichage. De plus, les pistes conductrices 166 sont formées de manière à connecter une extrémité des vias 152 à la face libre des couches 162. De préférence, les couches 110 et 142 recouvrent entièrement les faces des circuits électronique 101 et optoélectronique 121 sur lesquelles elles sont formées avant la formation des tranchées 160. Après la formation des tranchées 160, les couches 110 et 142 recouvrent, de préférence, entièrement les faces des circuits électronique 101 et optoélectronique 121 sur lesquelles elles sont formées à l'exception des tranchées 160, qui les traversent.

La couche 168 métallique est déposée sur la face libre de l'empilement de couches isolantes 162. Cette couche 168 est donc en contact avec les éléments conducteurs 166 et est donc connectée à une piste conductrice 105.

Les tranchées 160 sont donc formées après la mise en contact du circuit optoélectronique 121 et du circuit électronique 121.

La figure 8 illustre le résultat d'une étape au cours de laquelle des tranchées sont creusées entre des pixels d'affichage 169 de manière à les individualiser. Les pixels d'affichage 169 restent néanmoins fixés à la poignée 140.

Pour former un écran d'affichage, un certain nombre de pixels d'affichage 169 sont déposés sur le support 170. Pour ce faire, les plots 172 métalliques sont formés aux emplacements voulus des pixels d'affichage 169. La poignée 140 est alors placée de manière à mettre un pixel d'affichage en regard de chaque plot métallique 172. Les écarts entre les plots 172 sont de préférence choisis pour que chaque pixel d'affichage 169 d'un écran d'affichage puisse être placé, en même temps, en regard du plot 172 correspondant. Alternativement, les pixels d'affichage peuvent être déposés en plusieurs fois. Les pixels d'affichage 169 sont ensuite mis en contact avec les plots 172 de manière à fixer par collage moléculaire le plot 172 à la couche 168 métallique, qui est commune à tous les sous-pixels d'affichage de chaque pixel d'affichage 169. La poignée 140 et les pixels d'affichage n'ayant pas été accolés à des plots 172 sont ensuite retirés.

Au cours d'une étape ultérieure non représentée, une couche isolante est déposée sur le support 170 et sur les pixels d'affichages de telle manière qu'une extrémité de chaque mur 132 de chaque pixel d'affichage 169 reste découverte. La couche conductrice 133 est alors déposée sur la couche isolante, en contact avec les murs 132.

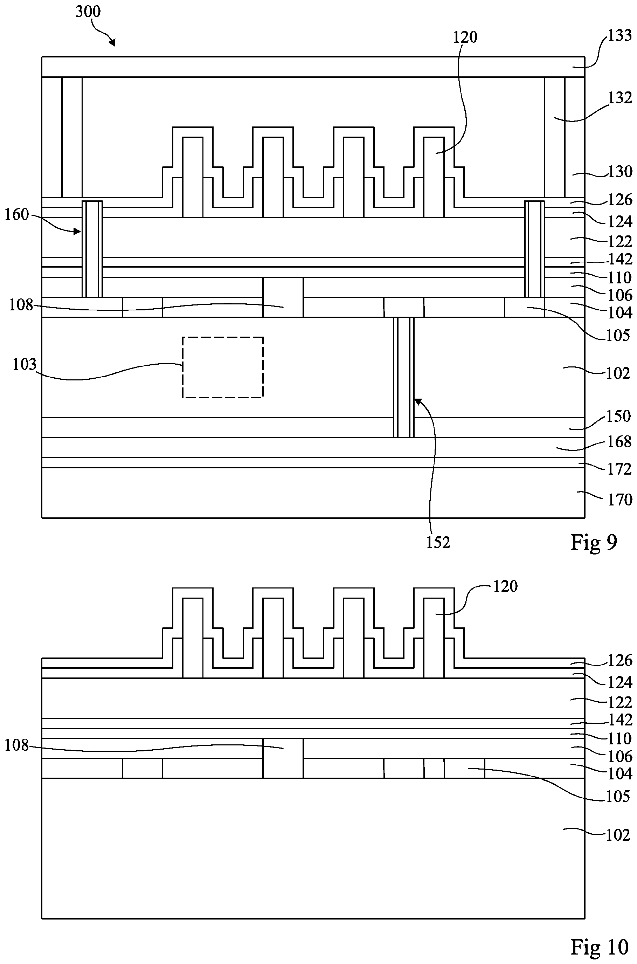

La figure 9 illustre une partie d'un autre mode de réalisation d'un dispositif optoélectronique 300. Plus précisément, la figure 9 illustre un sous-pixel d'affichage d'un pixel d'affichage du dispositif optoélectronique 300.

Le sous-pixel d'affichage de la figure 9 comprend l'ensemble des éléments du sous-pixel de la figure 1 à la différence que les tranchées 160 du mode de réalisation de la figure 9 traversent uniquement la couche isolante 106, les couches métalliques 110 et 142, le substrat 122 et la couche isolante 124. Ainsi, en fonctionnement, l'ensemble de composants électroniques 103 reçoit le premier potentiel d'alimentation par l'intermédiaire de la couche conductrice 133, des murs 132, des tranchées 160, et de pistes conductrices 105.

La présence des vias 154 et des pistes conductrices 164 n'est plus nécessaire pour connecter la couche conductrice 133 à l'ensemble de composants électroniques.

De préférence, les couches 110 et 142 recouvrent entièrement, respectivement, les faces du circuit électronique 101 et du circuit optoélectronique 121 sur lesquelles elles sont formées, à l'exception des tranchées 160.

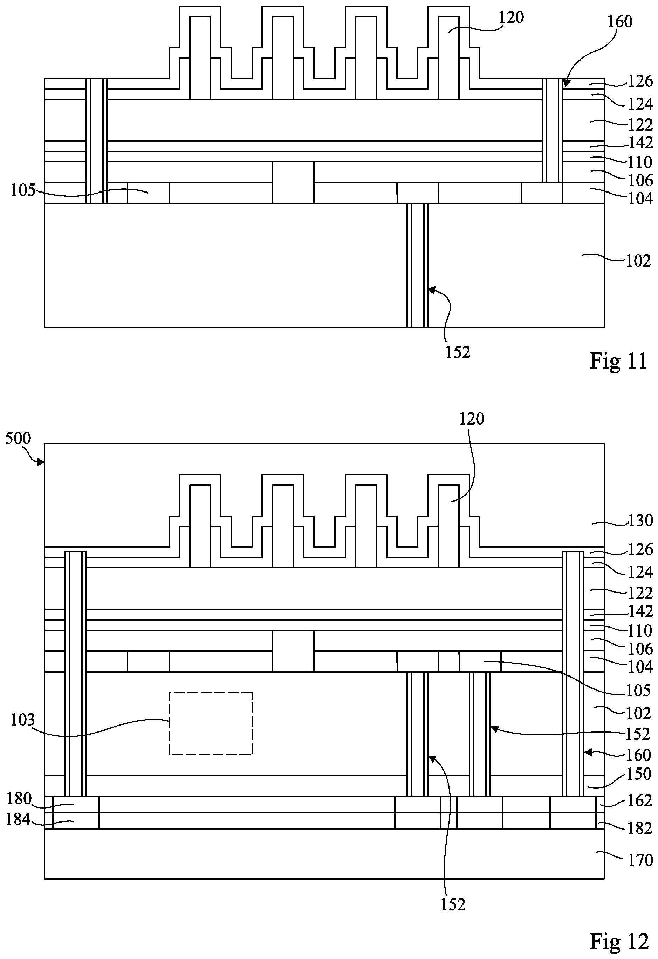

Les figures 10 et 11 illustrent les résultats d'étapes, de préférence successives, d'un mode de réalisation d'un procédé de fabrication du dispositif optoélectronique 300 de la figure 9.

La figure 10 illustre le résultat d'étapes comprenant des premières étapes similaires aux étapes décrites en relation avec les figures 2 et 3.

Le substrat 122 est ensuite aminci. L'épaisseur du substrat 122 est cependant maintenue suffisamment épaisse pour que la manipulation du substrat 122 ne nécessite pas l'utilisation d'une poignée. La couche 142 métallique est ensuite déposée sur la face libre du substrat 122. Les couches métalliques 142 et 110 sont ensuite mises en contact de manière à fixer la plaque de circuits électroniques 101 et la plaque de circuits optoélectroniques 121 par collage moléculaire comme cela été décrit précédemment.

La figure 11 illustre le résultat d'étapes au cours desquelles les tranchées conductrices isolées 160 sont formées, depuis la face libre de la couche conductrice 126. Les tranchées 160 comprennent un coeur conducteur électriquement et une gaine isolante électriquement. Les gaines sont formées de telle manière que le coeur conducteur est en contact avec la couche conductrice 126 formant l'électrode. Les tranchées 160 sont formées de manière à atteindre par endroits des pistes conductrices 105.

Les tranchées 160 sont donc formées après la mise en contact du circuit optoélectronique 121 et du circuit électronique 121.

Les vias conducteurs isolés 152 sont formés à travers le substrat 102 de manière à former une connexion entre la face libre du substrat 102 et des pistes conductrices 105.

De préférence, les couches 110 et 142 recouvrent entièrement les faces des circuits électronique 101 et optoélectronique 121 sur lesquelles elles sont formées avant la formation des tranchées 160. Après la formation des tranchées 160, les couches 110 et 142 recouvrent, de préférence, entièrement les faces des circuits électroniques 101 et optoélectronique 121 sur lesquelles elles sont formées à l'exception des tranchées 160, qui les traversent.

Au cours d'étapes ultérieures, les murs conducteurs 132 sont formés sur la couche 126. La couche photoluminescente 130 de chaque sous-pixel est déposée sur les diodes électroluminescentes du sous-pixel concerné.

Dans l'exemple des figures 1 et 9, les murs 132 ne sont pas en contact avec les tranchées 160. À titre de variante, les murs 132 des modes de réalisation des figures 1 et 9 peuvent être formés directement en contact avec une extrémité des tranchées 160. Éventuellement, les murs 132 peuvent être en contact avec la couche conductrice 126 et une extrémité des tranchées 160.

Au cours de ces étapes ultérieures, une poignée, non représentée, est aussi formée sur les couches photoluminescentes 130. De plus, la couche conductrice 168 est formée sur la face libre du substrat 102, connectée aux vias 152. Les pixels d'affichage sont ensuite individualisés. Les pixels d'affichage et les sous-pixels d'affichage sont ainsi prêts à être déposés sur le support 170 de manière à former un écran d'affichage, comme cela a été décrit précédemment en relation avec la figure 8. La couche conductrice 133 est ensuite déposée sur les sous-pixels d'affichage.

A titre de variante des modes de réalisation illustrés sur les figures précédentes, les couches métalliques 142 et 110 peuvent ne recouvrir que partiellement le substrat 122 et la couche 106. Les parties non recouvertes par les couches 142 et 110 peuvent être recouvertes d'un autre matériau, par exemple un matériau isolant. La plaque de circuits optoélectroniques et la plaque de circuits électroniques sont alors fixées par collage moléculaire hybride.

La figure 12 illustre une partie d'un autre mode de réalisation d'un dispositif optoélectronique 500. Plus précisément, la figure 12 illustre un sous-pixel d'affichage d'un pixel d'affichage du dispositif optoélectronique 500.

Contrairement aux sous-pixels d'affichage des figures 1 et 9, le sous-pixel d'affichage du mode de réalisation représenté en figure 12 ne comprend ni couche conductrice 133 recouvrant la couche isolante 130 ni murs conducteurs 132 dans la couche photoluminescente 130.

Les tranchées 160 traversent, comme dans le mode de réalisation de la figure 1, la couche isolante 124, le substrat 122, les couches métalliques 142 et 110, les couches isolantes 106 et 104, le substrat 102 et la couche isolante 150. Ainsi, les tranchées 160 connectent l'électrode 126 à des pistes conductrices 180 situées dans les couches isolantes 162. Eventuellement, il peut n'y avoir qu'une couche isolante 162.

De préférence, les couches 110 et 142 recouvrent entièrement, respectivement, les faces du circuit électronique 101 et du circuit optoélectronique 121 sur lesquelles elles sont formées, à l'exception des tranchées 160.

Le support 170 n'est pas recouvert de la couche métallique 172 mais d'un empilement d'au moins une couche isolante 182 et de pistes conductrices 184. Les pistes 184 sont situées de telle manière que chaque piste 180 soit en contact avec une piste 184. Les couches 182 et 162 sont ainsi collées par collage moléculaire hybride. Eventuellement, les couches 182 et 162 peuvent être collées d'une autre manière. De telles autres manières sont décrites dans les brevets US 8898896 B2 et US 8586409 B2.

En fonctionnement, une tension est appliquée à l'électrode 126 par l'intermédiaire des pistes 184 et 180 et des tranchées 160, les pistes conductrices 184 pouvant par exemple s'étendre dans la couche isolante 182 jusqu'à d'autres plots non représentés. Chaque ensemble de composants électroniques est connecté à des sources de tension, par exemple à une source de tension d'alimentation et à la masse, par l'intermédiaire de pistes conductrices 180 et 184, de vias conducteurs isolés 152 et de pistes conductrices 105.

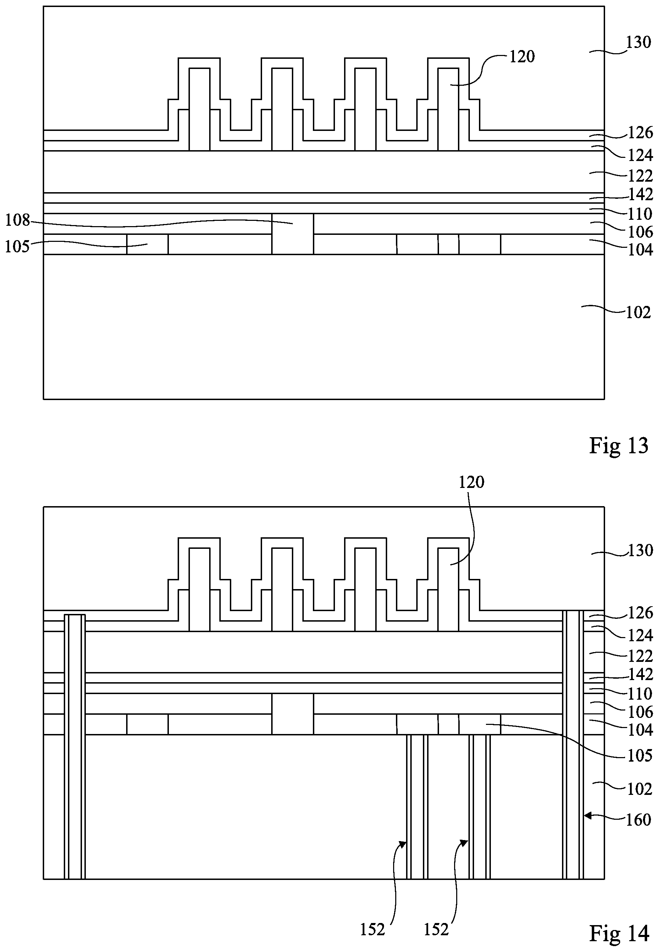

Les figures 13 et 14 illustrent les résultats d'étapes, de préférence successives, d'un mode de réalisation d'un procédé de fabrication du dispositif optoélectronique 500 de la figure 12.

La figure 13 illustre le résultat d'étapes comprenant des premières étapes similaires aux étapes décrites précédemment en relation avec les figures 2 et 3. La couche isolante 130 est ensuite déposée sur l'électrode 126 pour chaque sous-pixel d'affichage. Cependant, les murs 132 ne sont pas formés. Une poignée, non représentée, est aussi fixée aux couches photoluminescentes 130, de manière à pouvoir manipuler la plaque de circuits optoélectroniques. La couche métallique 142 est déposée sur la face libre du substrat 122. Les couches métalliques 110 et 142 sont fixées l'une à l'autre par collage moléculaire métal/métal. A titre de variante, le substrat 122 peut être entièrement retiré.

La figure 14 illustre le résultat d'étapes au cours desquelles des vias conducteurs isolés 152 sont formés depuis la face libre du substrat 102 de manière à atteindre des pistes conductrices 105. Des tranchées conductrices isolantes 160 sont formées à partir de la face libre du substrat 102 et entourent chaque sous-pixel d'affichage. Les tranchées 160 traversent le substrat 102, les couches 104 et 106, les couches métalliques 142 et 110, le substrat 122, et la couche isolante 124. Ainsi, les tranchées isolantes 160 forment une connexion entre la face libre du substrat 102 et l'électrode 126.

Les tranchées 160 sont donc formées après la mise en contact du circuit optoélectronique 121 et du circuit électronique 121.

De préférence, les couches 110 et 142 recouvrent entièrement les faces des circuits électronique 101 et optoélectronique 121 sur lesquelles elles sont formées avant la formation des tranchées 160. Après la formation des tranchées 160, les couches 110 et 142 recouvrent, de préférence, entièrement les faces des circuits électronique 101 et optoélectronique 121 sur lesquelles elles sont formées à l'exception des tranchées 160, qui les traversent.

Au cours d'étapes ultérieures, la couche isolante 162 et les pistes conductrices 180 sont formées.

Les pixels d'affichage et les sous-pixels d'affichage sont prêts à être déposés sur une puce de manière à former un écran d'affichage. Une étape similaire à l'étape décrite en relation avec la figure 8 est effectuée après les étapes dont le résultat est illustré en figure 14. Il n'est pas nécessaire de déposer une couche conductrice sur les couches photoluminescentes 130 après le retrait de la poignée. Il n'y a pas de murs conducteurs permettant la connexion avec l'électrode 126. De plus, chaque pixel d'affichage n'est pas déposé sur un unique plot, comme cela est décrit précédemment en relation avec la figure 8, mais sur la couche isolante 182 et les pistes conductrices 184 de manière à pouvoir connecter séparément les tranchées 160 et les différents vias 152.

Un avantage des tranchées 160 est qu'elles permettent d'isoler les parties des couches 110 et 142 de chaque sous-pixel d'affichage et d'individualiser la connexion de chaque ensemble de diodes électroluminescentes.

Un avantage des modes de réalisation décrits précédemment est que le positionnement, d'une part du substrat 122 sur le substrat 102, et d'autre part des pixels d'affichage 169 sur les puces formant des écran d'affichage, est fait en manipulant les plaques entières et pas seulement des éléments un à un. Ainsi, le procédé est plus rapide qu'un procédé utilisant une technique dite "pick and place".

Un avantage des modes de réalisation décrits précédemment est que, pour chaque sous-pixel d'affichage, la connexion entre l'ensemble de diodes électroluminescentes et l'ensemble de composants électroniques 103 associés est faite par l'intermédiaire des couches 142 et 110. Ainsi, il n'est pas nécessaire que les ensembles de diodes électroluminescentes et les ensembles de composants électroniques 103 soient parfaitement alignés. Cela est aussi le cas pour la connexion entre les pixels d'affichage 169 et les plots 172 dans les modes de réalisation des figures 1 et 9.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art.

Enfin, la mise en oeuvre pratique des modes de réalisation et variantes décrits est à la portée de l'homme du métier à partir des indications fonctionnelles données cidessus.

## Revendications

1. Procédé de fabrication d'un dispositif optoélectronique (100, 300, 500) comprenant les étapes suivantes :
former, sur une première face d'une première plaque (102) comprenant des ensembles de composants électroniques (103), un empilement de premières couches isolantes (104, 106) et de pistes conductrices (105) ;
former, sur une deuxième plaque (122), des ensembles de diodes électroluminescentes tridimensionnelles (120) comprenant chacune des première et deuxième extrémités ;
former une première couche métallique (110) sur au moins une partie de la première face de la première plaque et une deuxième couche métallique (142) sur au moins une partie d'une première face de la deuxième plaque, la deuxième couche métallique étant couplée électriquement à la première extrémité de chaque diode électroluminescente (120) ;
mettre en contact les première et deuxième couches métalliques (110, 142) pour les fixer par collage moléculaire ;
former au moins un via conducteur isolé (152, 154) connectant une seconde face de la première plaque à l'une des pistes conductrices (105) ; et
former, après la mise en contact des premières et deuxième couches métalliques, des tranchées conductrices isolées (160) entourant chaque ensemble de diodes électroluminescentes et isolant latéralement les unes des autres des parties des première et deuxième couches métalliques (110, 142), chaque partie étant connectée à l'un des ensembles de diodes électroluminescentes.

2. Procédé selon la revendication 1, dans lequel certaines des pistes conductrices (105) connectent entre eux des composants électroniques de la première plaque et dans lequel des éléments conducteurs (108) s'étendent dans les premières couches isolantes de l'empilement (104, 106) et sont en contact avec la première couche métallique (110).

3. Procédé selon la revendication 2, dans lequel chaque partie des première et deuxième couches métalliques (110, 142) entourée par une tranchée (160) est connectée à la première plaque par l'un des éléments conducteurs (108).

4. Procédé selon l'une quelconque des revendications 1 à 3, dans lequel les première et deuxième couches métalliques (110, 142) recouvrent, avant la formation des tranchées conductrices isolées (160), entièrement les premières faces des première et deuxième plaques (102, 122).

5. Procédé selon l'une quelconque des revendications 1 à 4, comprenant une étape de formation d'une électrode (126) connectant électriquement les deuxièmes extrémités de toutes les diodes électroluminescentes (120).

6. Procédé selon la revendication 5, dans lequel les tranchées conductrices (160) isolées s'étendent de l'électrode (126) à certaines des pistes conductrices (105) .

7. Procédé selon la revendication 5, dans lequel les tranchées conductrices isolées (160) s'étendent de la seconde face de la première plaque jusqu'à l'électrode (126) .

8. Procédé selon l'une quelconque des revendications 4 à 7, dans lequel les première et deuxième couches métalliques (110, 142) sont mises en contact avant la formation d'une couche photoluminescente (130) recouvrant l'électrode (126) .

9. Procédé selon l'une quelconque des revendications 1 à 8, dans lequel chaque tranchée (160) est connectée à l'un des vias conducteurs isolés (154).

10. Procédé selon l'une quelconque des revendications 1 à 9, comprenant la formation d'une deuxième couche isolante (130) électriquement recouvrant les diodes électroluminescentes, la deuxième couche isolante étant traversée par des murs conducteurs électriquement (132).

11. Dispositif optoélectronique (100, 300, 500) comprenant :
une première plaque comprenant des ensembles de composants électroniques et un empilement de premières couches isolantes (104, 106) et des pistes conductrices (105), une première face de la première plaque étant au moins partiellement recouverte d'une première couche métallique (110), au moins un via conducteur isolé (154) connectant une seconde face de la première plaque à l'une des pistes conductrices ;
une deuxième plaque comprenant des ensembles de diodes électroluminescentes tridimensionnelles (120), chaque diode électroluminescentes ayant une première et une deuxième extrémité, une première face de la deuxième plaque étant au moins partiellement recouverte d'une deuxième couche métallique (142), la deuxième couche métallique étant couplée électriquement aux premières extrémités de toutes les diodes électroluminescentes, les première et deuxième couches métalliques (110, 142) étant fixées l'une à l'autre par collage moléculaire ; et
des tranchées conductrices isolées (160) entourant chaque ensemble de diodes électroluminescentes et isolant latéralement des parties des première et deuxième couches métalliques connectées à chaque ensemble de diodes électroluminescentes.

12. Dispositif selon la revendication 11, dans lequel certaines des pistes conductrices (105) connectent entre eux des composants électroniques de la première plaque et des éléments conducteurs (108) compris dans les premières couches isolantes de l'empilement (104, 106) sont en contact avec la première couche métallique (110).

13. Dispositif selon la revendication 12, dans lequel chaque partie des première et deuxième couches métalliques (110, 142) entourée par une tranchée est connectée à la première plaque par l'un des éléments conducteurs (108).

14. Dispositif selon l'une quelconque des revendications 11 à 13, dans lequel les première et deuxième couches métalliques (110, 142) recouvrent entièrement les premières faces des première et deuxième plaques.

15. Dispositif selon l'une quelconque des revendications 11 à 14, dans lequel une électrode (126) connecte électriquement les deuxièmes extrémités toutes les diodes électroluminescentes (120).

16. Dispositif selon la revendication 15, dans lequel les tranchées conductrices isolées (160) s'étendent de l'électrode (126) à une piste conductrice de l'empilement (104, 106).

17. Dispositif selon la revendication 15, dans lequel les tranchées conductrices isolées (160) s'étendent de la seconde face de la première plaque à l'électrode (126).

18. Dispositif selon l'une quelconque des revendications 11 à 17, dans lequel chaque tranchée (160) est connectée à un des vias conducteurs isolés (154).

19. Dispositif selon l'une quelconque des revendications 11 à 18, dans lequel une deuxième couche isolante électriquement (130) recouvre les diodes électroluminescentes (120), la couche isolante étant traversée par des murs conducteurs électriquement (132).

20. Dispositif selon l'une quelconque des revendications 11 à 19, dans lequel la deuxième couche métallique (142) est en contact avec les premières extrémités des diodes électroluminescentes (120).

## Patentansprüche

1. Ein Verfahren zur Herstellung einer optoelektronischen Vorrichtung (100, 300, 500), das die folgenden Schritte aufweist:
Ausbilden, auf einer ersten Oberfläche eines ersten Wafers (102), welche Anordnungen elektronischer Komponenten (103) aufweist, eines Stapels aus ersten Isolierschichten (104, 106) und Leiterbahnen (105);
Ausbilden, auf einem zweiten Wafer (122), von Anordnungen dreidimensionaler Leuchtdioden (120), die jeweils ein erstes und ein zweites Ende aufweisen;
Ausbilden einer ersten Metallschicht (110) auf mindestens einem Teil der ersten Oberfläche des ersten Wafers und einer zweiten Metallschicht (142) auf mindestens einem Teil einer ersten Oberfläche des zweiten Wafers, wobei die zweite Metallschicht elektrisch mit dem ersten Ende jeder Leuchtdiode (120) verbunden ist;
In-Kontakt-Bringen der ersten und der zweiten Metallschicht (110, 142), um sie durch molekulares Bonden zu verbinden;
Ausbilden mindestens einer isolierten leitenden Durchkontaktierung (152, 154), die eine zweite Oberfläche des ersten Wafers mit einer der Leiterbahnen (105) verbindet; und
Ausbilden, nach dem In-Kontakt-Bringen der ersten und der zweiten Metallschicht, von isolierten leitenden Gräben (160), die jede Anordnung von Leuchtdioden umgeben und Teile der ersten und zweiten Metallschicht (110, 142) seitlich voneinander isolieren, wobei jeder Teil mit einer der Anordnungen von Leuchtdioden verbunden ist.

2. Verfahren nach Anspruch 1, wobei einige der Leiterbahnen (105) elektronische Komponenten des ersten Wafers miteinander verbinden und wobei sich leitende Elemente (108) in den ersten Isolierschichten des Stapels (104, 106) erstrecken und in Kontakt mit der ersten Metallschicht (110) stehen.

3. Verfahren nach Anspruch 2, wobei jeder Teil der ersten und zweiten Metallschichten (110, 142), der von einem Graben (160) umgeben ist, durch eines der leitenden Elemente (108) mit dem ersten Wafer verbunden ist.

4. Verfahren nach einem der Ansprüche 1 bis 3, wobei die ersten und zweiten Metallschichten (110, 142) vor dem Ausbilden von isolierten, leitenden Gräben (160) die ersten Oberflächen des ersten und des zweiten Wafers (102, 122) vollständig bedecken.

5. Verfahren nach einem der Ansprüche 1 bis 4, wobei das Verfahren einen Schritt des Ausbildens einer Elektrode (126) aufweist, die die zweiten Enden aller Leuchtdioden (120) elektrisch verbindet.

6. Verfahren nach Anspruch 5, wobei sich die isolierten, leitenden Gräben (160) von der Elektrode (126) zu einigen der Leiterbahnen (105) erstrecken.

7. Verfahren nach Anspruch 5, wobei sich die isolierten, leitenden Gräben (160) von der zweiten Oberfläche des ersten Wafers zur Elektrode (126) erstrecken.

8. Verfahren nach einem der Ansprüche 4 bis 7, wobei die erste und die zweite Metallschicht (110, 142) vor dem Ausbilden einer photolumineszierenden Schicht (130), die die Elektrode (126) bedeckt, in Kontakt gebracht werden.

9. Verfahren nach einem der Ansprüche 1 bis 8, wobei jeder Graben (160) mit einer der isolierten leitenden Durchkontaktierungen (154) verbunden wird.

10. Verfahren nach einem der Ansprüche 1 bis 9, aufweisend das Ausbilden einer zweiten elektrisch isolierende Schicht (130), die die lichtemittierenden Dioden abdeckt, wobei die zweite isolierende Schicht von elektrisch leitenden Wänden (132) gequert wird.

11. Optoelektronisches Bauelement (100, 300, 500), das Folgendes aufweist:
einen ersten Wafer mit Anordnungen elektronischer Komponenten und einem Stapel von ersten Isolierschichten (104, 106) und Leiterbahnen (105), wobei eine erste Oberfläche des ersten Wafers zumindest teilweise mit einer ersten Metallschicht (110) abgedeckt ist, wobei mindestens eine isolierte leitende Durchkontaktierung (154) eine zweite Oberfläche des ersten Wafers mit einer der Leiterbahnen verbindet;
einen zweiten Wafer mit Anordnungen von dreidimensionalen lichtemittierenden Dioden (120), wobei jede lichtemittierende Diode ein erstes und ein zweites Ende aufweist, wobei eine erste Oberfläche des zweiten Wafers zumindest teilweise mit einer zweiten Metallschicht (142) abgedeckt ist, wobei die zweite Metallschicht elektrisch mit den ersten Enden aller lichtemittierenden Dioden gekoppelt ist, wobei die erste und die zweite Metallschicht (110, 142) durch molekulares Bonden miteinander verbunden sind; und
isolierte, leitende Gräben (160), die jede Anordnung von Leuchtdioden umgeben, und Teile der ersten und zweiten Metallschicht, die mit jeder Anordnung von Leuchtdioden verbunden sind, seitlich isolieren.

12. Vorrichtung nach Anspruch 11, wobei einige der Leiterbahnen (105) elektronische Komponenten des ersten Wafers miteinander verbinden und leitende Elemente (108), die in den ersten isolierenden Schichten des Stapels (104, 106) enthalten sind, in Kontakt mit der ersten Metallschicht (110) stehen.

13. Vorrichtung nach Anspruch 12, wobei jeder Teil der ersten und zweiten Metallschichten (110, 142), der von einem Graben umgeben ist, mit dem ersten Wafer durch eines der leitenden Elemente (108) verbunden ist.

14. Vorrichtung nach einem der Ansprüche 11 bis 13, wobei die ersten und zweiten Metallschichten (110, 142) die ersten Oberflächen des ersten und zweiten Wafers vollständig abdecken.

15. Vorrichtung nach einem der Ansprüche 11 bis 14, wobei eine Elektrode (126) die zweiten Enden aller lichtemittierenden Dioden (120) elektrisch verbindet.

16. Vorrichtung nach Anspruch 15, wobei sich die isolierten, leitenden Gräben (160) von der Elektrode (126) zu einer Leiterbahn des Stapels (104, 106) erstrecken.

17. Vorrichtung nach Anspruch 15, wobei sich die isolierten, leitenden Gräben (160) von der zweiten Oberfläche des ersten Wafers zur Elektrode (126) erstrecken.

18. Vorrichtung nach einem der Ansprüche 11 bis 17, wobei jeder Graben (160) mit einer der isolierten, leitenden Durchkontaktierungen (154) verbunden ist.

19. Vorrichtung nach einem der Ansprüche 11 bis 18, wobei eine zweite elektrisch isolierender Schicht (130) die Leuchtdioden (120) abdeckt, wobei die isolierende Schicht von elektrisch leitenden Wänden (132) gequert wird.

20. Vorrichtung nach einem der Ansprüche 11 bis 19, wobei die zweite Metallschicht (142) in Kontakt mit den ersten Enden der Leuchtdioden (120) steht.

## Claims

1. A method of manufacturing an optoelectronic device (100, 300, 500), comprising the steps of:
forming, on a first surface of a first wafer (102) comprising assemblies of electronic components (103), a stack of first insulating layers (104, 106) and of conductive tracks (105);
forming, on a second wafer (122), assemblies of three-dimensional light-emitting diodes (120), each comprising first and second ends;
forming a first metal layer (110) on at least a portion of the first surface of the first wafer and a second metal layer (142) on at least a portion of a first surface of the second wafer, the second metal layer being electrically coupled to the first end of each light-emitting diode (120);
placing into contact the first and second metal layers (110, 142) to bond them by molecular bonding;
forming at least one insulated conductive via (152, 154) connecting a second surface of the first wafer to one of the conductive tracks (105); and
forming, after putting into contact the first and second metal layers, insulated conductive trenches (160) surrounding each assembly of light-emitting diodes and laterally insulating from one another portions of the first and second metal layers (110, 142), each portion being connected to one of the assemblies of light-emitting diodes.

2. The method according to claim 1, wherein some of the conductive tracks (105) interconnect electronic components of the first wafer and wherein conductive elements (108) extend in the first insulating layers of the stack (104, 106) and are in contact with the first metal layer (110).

3. The method according to claim 2, wherein each portion of the first and second metal layers (110, 142) surrounded with a trench (160) is connected to the first wafer by one of the conductive elements (108).

4. The method according to any of claims 1 to 3, wherein the first and second metal layers (110, 142) totally cover, before the formation of insulated conductive trenches (160), the first surfaces of the first and second wafers (102, 122).

5. The method according to any of claims 1 to 4, comprising a step of forming of an electrode (126) electrically connecting the second ends of all the light-emitting diodes (120) .

6. The method according to claim 5, wherein the insulated conductive trenches (160) extend from the electrode (126) to some of the conductive tracks (105).

7. The method according to claim 5, wherein the insulated conductive trenches (160) extend from the second surface of the first wafer to the electrode (126).

8. The method according to any of claims 4 to 7, wherein the first and second metal layers (110, 142) are placed into contact before the forming of a photoluminescent layer (130) covering the electrode (126).

9. The method according to any of claims 1 to 8, wherein each trench (160) is connected to one of the insulated conductive vias (154).

10. The method according to any of claims 1 to 9, comprising the forming of a second electrically-insulating layer (130) covering the light-emitting diodes, the second insulating layer being crossed by electrically-conductive walls (132).

11. An optoelectronic device (100, 300, 500) comprising:
a first wafer comprising assemblies of electronic components and a stack of first insulating layers (104, 106) and of conductive tracks (105), a first surface of the first wafer being at least partially covered with a first metal layer (110), at least one insulated conductive via (154) connecting a second surface of the first wafer to one of the conductive tracks;
a second wafer comprising assemblies of three-dimensional light-emitting diodes (120), each light-emitting diode having a first and a second end, a first surface of the second wafer being at least partially covered with a second metal layer (142), the second metal layer being electrically coupled to the first ends of all the light-emitting diodes, the first and second metal layers (110, 142) being bonded to each other by molecular bonding; and
insulated conductive trenches (160) surrounding each assembly of light-emitting diodes and laterally insulating portions of the first and second metal layers connected to each assembly of light-emitting diodes.

12. The device according to claim 11, wherein some of the conductive tracks (105) interconnect electronic components of the first wafer and conductive elements (108) comprised within the first insulating layers of the stack (104, 106) are in contact with the first metal layer (110).

13. The device according to claim 12, wherein each portion of the first and second metal layers (110, 142) surrounded with a trench is connected to the first wafer by one of the conductive elements (108).

14. The device according to any of claims 11 to 13, wherein the first and second metal layers (110, 142) totally cover the first surfaces of the first and second wafers.

15. The device according to any of claims 11 to 14, wherein an electrode (126) electrically connected the second ends of all the light-emitting diodes (120).

16. The device according to claim 15, wherein the insulated conductive trenches (160) extend from the electrode (126) to a conductive track of the stack (104, 106) .

17. The device according to claim 15, wherein the insulated conductive trenches (160) extend from the second surface of the first wafer to the electrode (126).

18. The device according to any of claims 11 to 17, wherein each trench (160) is connected to one of the insulated conductive vias (154).

19. The device according to any of claims 11 to 18, wherein a second electrically-insulating trench (130) covers the light-emitting diodes (120), the insulating layer being crossed by electrically-conductive walls (132).

20. The device according to any of claims 11 to 19, wherein the second metal layer (142) is in contact with the first ends of the light-emitting diodes (120).
